# EUROPEAN PATENT APPLICATION

(11) **EP 4 628 989 A1**
(43) Date of publication of application: **08.10.2025**
(21) Application number: 24875760.1
(22) Date of filing: 25.11.2024
(51) Int. Cl.: G03F 7/11, B41C 1/00, B41N 1/00, G06F 7/00

(54) **LAMINATE FOR PRODUCING WATER-DEVELOPABLE FLEXOGRAPHIC PRINTING ORIGINAL PLATE**

(30) Priority: 22.02.2024 JP 2024025250
(71) Applicant: TOYOBO MC Corporation, Osaka 530-0001 (JP)
(72) Inventor: YOSHIMOTO, Kazuya, Okayama-shi, Okayama 704-8194 (JP)
(74) Representative: Müller-Boré & Partner Patentanwälte PartG mbB
(86) International application number: PCT/JP2024/041685
(87) International publication number: WO 2025/177651

(57) **Abstract**

The present invention provides a laminate for producing a water-developable flexographic printing plate precursor which enables appropriate peeling of a cover film from a photosensitive resin layer even when the laminate has been stored in an environment having large variations in temperature and humidity, provided that the laminate is of the types wherein a functional resin layer is provided separately from the laminate, and wherein the functional resin layer comprises a photosensitive resin layer having strong surface adhesive force. A laminate for producing a water-developable flexographic printing plate precursor, comprising a base film, a photosensitive resin layer, and a cover film stacked in this order, wherein a release layer is provided between the photosensitive resin layer and the cover film and in contact with the photosensitive resin layer and the cover film, and wherein the release layer contains an addition silicone polymer and a curing catalyst.

## Description

### Technical Field

The present invention relates to a laminate for producing a high-resolution water-developable flexographic printing plate precursor, comprising a base film, a photosensitive resin layer, and a cover film stacked in this order, wherein the laminate enables appropriate peeling of the cover film from the photosensitive resin layer.

### Background Art

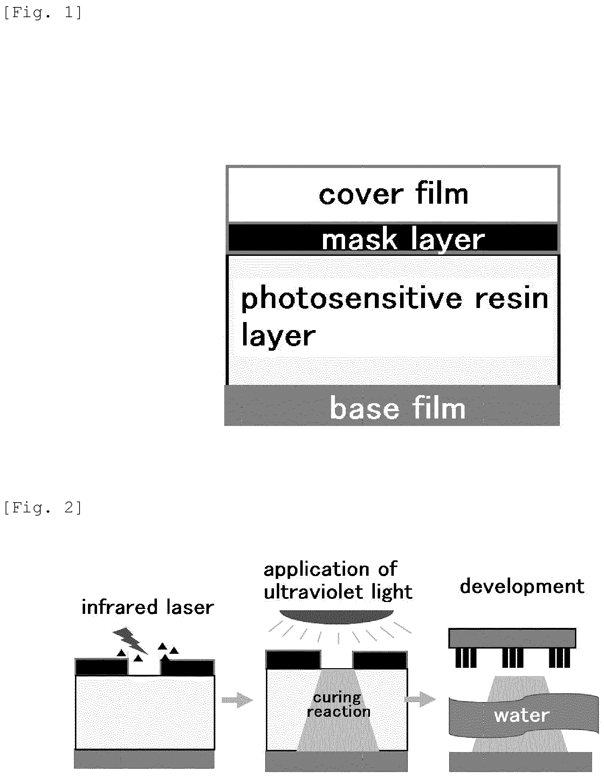

As illustrated in FIG. 1, a general flexographic printing plate precursor consists of a laminate comprising a base film, a photosensitive resin layer, a mask layer, and a cover film stacked in this order. The cover film is used for preventing dirt from being attached to the mask layer, and for preventing damage from being caused on the mask layer during the storage of the flexographic printing plate precursor after the production thereof till the actual use of thereof for making a printing plate. Accordingly, in the use, the cover film is removed. Then, as illustrated in FIG. **2****,** a desired pattern is drawn on the mask layer by an infrared laser. Next, ultraviolet light is applied from the mask-layer side so as to cure the photosensitive resin layer along the pattern of the mask layer. Finally, development is performed with a developer such as water so as to obtain a flexographic printing plate.

In this general type, a release layer (not illustrated) is provided between the cover film and the mask layer so as to facilitate appropriate removal of the cover film. As to a constituent material for this release layer, there is used an amino resin (see Patent Document 1), an acrylic resin (see Patent Document 2), or the like capable of uniformly forming a layer between the cover film and the mask layer.

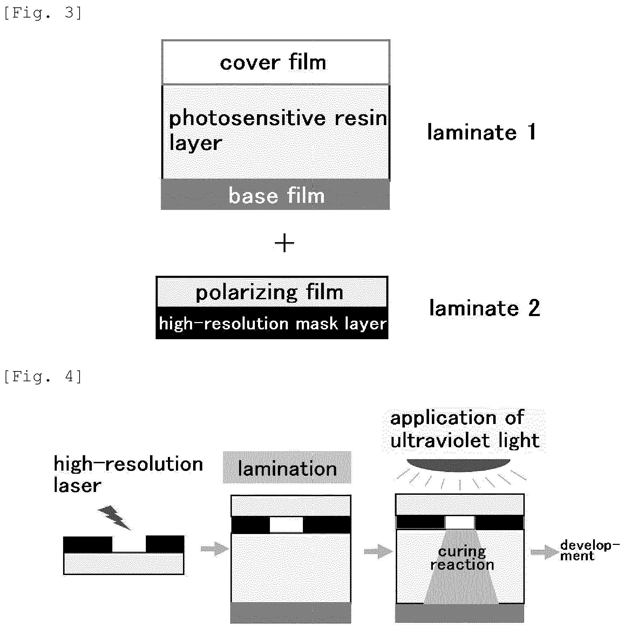

On the other hand, recently, a demand for a higher-resolution flexographic printing plate precursor is increasing. The general type of flexographic printing plate precursor described above has a limit on the resolution of the mask layer and needs to be improved. In order to deal with this demand, it is proposed to design a mask layer separately from a photosensitive resin layer so as to form another laminate comprising a polarizing film and the mask layer provided thereon (see Patent Document 3). A pattern is drawn on the mask layer in this another laminate, and then this another laminate is stacked on the photosensitive resin layer. Specifically, as illustrated in FIG. 3, there are provided a laminate 1 comprising a base film, a photosensitive resin layer, and a cover film stacked in this order, and a laminate 2 comprising a mask layer and a polarizing film stacked in this order. Then, as illustrated in FIG. 4, a desired pattern is drawn on the mask layer of the laminate 2 by a high-resolution laser. Then, the laminate 2 is stacked on the photosensitive resin layer of the laminate 1 having the cover film removed therefrom in such a way that the side of the mask layer faces the photosensitive resin layer, whereby the laminate 1 and the laminate 2 are integrated. Then, ultraviolet light is applied from the polarizing-film side of the laminate 2 so as to cure the photosensitive resin layer along the drawn pattern of the mask layer. Finally, development is performed, whereby a flexographic printing plate is obtained.

Other than the type disclosed in Patent Document 3, there is also known a type wherein a mask layer having an image formed thereon, such as a high-resolution negative film; or a heat-sensitive mask layer on which an image is formed by laser abrasion is singly used as a mask layer separated from a photosensitive resin layer. There is further known a type wherein a layered product is produced by layering another photosensitive resin layer on the above-described mask layer. The another photosensitive resin layer may have a hardness different from that of the resin of the photosensitive resin layer; a concentration of photopolymerizable unsaturated groups or concentration of a photoinitiator different from that of the resin of the photosensitive resin layer; or a surface energy different from that of the resin of the photosensitive resin layer. In the present invention, these mask layers and another photosensitive resin layers are collectively called "functional resin layers".

In the above-described types wherein a functional resin layer is separately provided, a cover film for protection during storage is, unlike the general type, provided on the photosensitive resin layer of the laminate 1. In the peeling of the cover film from the photosensitive resin layer of the laminate 1, there is basically almost no problem when the laminate 1 has been stored in an environment having small variations in temperature and humidity. Therefore, a release layer has not been provided in the above-described conventional types wherein a functional resin layer is separately provided.

However, when the laminate 1 has been stored in an environment having large variations in temperature and humidity, the photosensitive resin layer has had a propensity for exhibiting an increased surface adhesive force. This is because the photosensitive resin layer contains a liquid component, such as a crosslinking monomer, and a low Tg polymer. Particularly, due to a recent increase in attention to the environment, a demand is increasing for a water-developable flexographic printing plate precursor which uses water instead of an organic solvent as a developer. However, when the photosensitive resin layer is designed to be water-developable (i.e. when the photosensitive resin layer is designed to have high-hydrophilicity) so as to make the flexographic printing plate precursor water-developable, the photosensitive resin layer has had a propensity for exhibiting a further increased surface adhesive force. Accordingly, in the above-described conventional types wherein a functional resin layer is provided separately from the laminate 1, when the laminate 1 has been stored in the environment having large variations in temperature and humidity, there is generated a problem that the photosensitive resin layer of the laminate 1 strongly adheres to the cover film during the storage, and thus the cover film cannot appropriately be peeled from the photosensitive resin layer.

### Prior Art Documents

### Patent Documents

Patent Document 1: Japanese Patent No. 5903854
Patent Document 2: Japanese Patent No. 6135040
Patent Document 3: Japanese Patent Application Laid-Open (JP-A) No. 2010-534345

### Disclosure of the Invention

### Problem that the Invention is to Solve

The present invention has been conceived of to resolve the problem of the conventional technique. An object of the present invention is to provide a laminate for producing a water-developable flexographic printing plate precursor which enables appropriate peeling of a cover film from a photosensitive resin layer even when the laminate has been stored in an environment having large variations in temperature and humidity, provided that the laminate is of the above-described types wherein a functional resin layer is provided separately from the laminate, and wherein the functional resin layer comprises a photosensitive resin layer having strong surface adhesive force.

### Means for Solving the Problem

In order to achieve this object, the inventor of the present invention has first studied about providing a release layer between a photosensitive resin layer and a cover film. Next, the inventor of the present invention has used, as a constituent material of this release layer, an amino resin (Patent Document 3) or an acrylic resin (Patent Document 4), which has been used as a constituent material of a release layer in the general type described above. Then, the inventor of the present invention has found that the appropriate peeling of a cover film from the photosensitive resin layer is not possible even when such a release layer is provided. The inventor of the present invention has found that this is because a water-developable photosensitive resin layer exhibits strong adhesive force. Then, the inventor of the present invention has used, as a constituent material of the release layer, one containing an addition silicone polymer which has not been able to be used in the general type, and a curing catalyst, and found that even when the photosensitive resin layer is water-developable, the appropriate peeling of a cover film from the photosensitive resin layer is possible. The present invention has thus been completed.

Thus, the present invention has been completed based on the above findings, and has the following configurations (1) to (7).
(1) A laminate for producing a water-developable flexographic printing plate precursor, comprising a base film, a photosensitive resin layer, and a cover film stacked in this order, wherein a release layer is provided between the photosensitive resin layer and the cover film and in contact with the photosensitive resin layer and the cover film, and wherein the release layer contains an addition silicone polymer and a curing catalyst.
(2) The laminate for producing a flexographic printing plate precursor according to (1), wherein the addition silicone polymer contains an alkenyl group at an end and/or a side chain thereof.
(3) The laminate for producing a flexographic printing plate precursor according to (1), wherein the curing catalyst is a hydrosilylation catalyst.
(4) The laminate for producing a flexographic printing plate precursor according to any of (1) to (3), wherein a surface of the release layer which surface contacts with the photosensitive resin layer has a surface roughness (Ra) of 0.01 to 0.2 µm.
(5) The laminate for producing a flexographic printing plate precursor according to any of (1) to (3), wherein a peel strength measured when the cover film is pulled together with the release layer from the laminate at a speed of 1000 mm/min and at an angle of 90° is 2.0 g/20 mm to 50.0 g/20 mm.
(6) The laminate for producing a flexographic printing plate precursor according to any of (1) to (3), wherein the photosensitive resin layer contains a conjugated diene-based polymer, a photopolymerizable unsaturated compound, and a photopolymerization initiator.
(7) A method for producing a flexographic printing plate precursor, wherein the method comprises peeling the cover film together with the release layer from the laminate for producing a flexographic printing plate precursor according to any of (1) to (3), and then directly stacking a resin layer surface of a functional resin layer on the photosensitive resin layer, so as to produce a flexographic printing plate precursor.

### Effects of the Invention

The laminate for producing a flexographic printing plate precursor according to the present invention exhibits excellent peeling properties of a release layer and storage stability even when the laminate has been stored in an environment having large variations in temperature and humidity. Accordingly, the laminate for producing a flexographic printing plate precursor according to the present invention enables appropriate peeling of the cover film from the photosensitive resin layer even when the laminate has been stored in an environment having large variations in temperature and humidity. Consequently, the laminate for producing a flexographic printing plate precursor according to the present invention can suitably be used in combination with a functional resin layer so as to stably produce a high-resolution water-developable flexographic printing plate precursor.

### Brief Description of the Drawings

FIG. 1 illustrates an example of a layer structure of a laminate constituting a flexographic printing plate precursor used in the general type.
FIG. 2 illustrates an example of steps of producing a flexographic printing plate produced by using the laminate shown in FIG. 1.
FIG. 3 illustrates an example of a layer structure of a laminate for producing a flexographic printing plate precursor used in the type wherein a functional resin layer is separately provided.
FIG. 4 illustrates an example of steps of producing a flexographic printing plate produced by using the laminate shown in FIG. 3.
FIG. 5 illustrates an example of a layer structure of a laminate for producing a flexographic printing plate precursor according to the present invention.

### Mode for Carrying Out the Invention

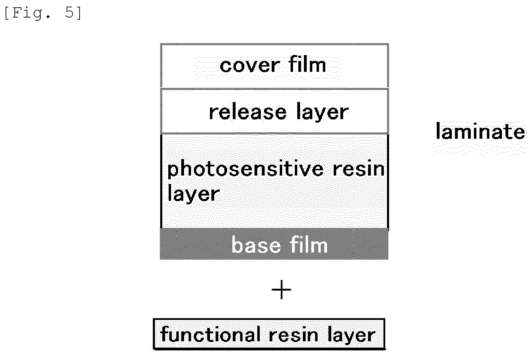

The laminate for producing a flexographic printing plate precursor according to the present invention has the same role as the laminate 1 (see Patent Document 3) for producing a flexographic printing plate precursor in the above-described type wherein a functional resin layer is separately provided. Specifically, as illustrated on the upper side in FIG. 5, the laminate for producing a water-developable flexographic printing plate precursor according to the present invention is a laminate comprising a base film, a photosensitive resin layer, and a cover film stacked in this order. The characteristic feature of the laminate of the present invention is that a release layer is provided between the photosensitive resin layer and the cover film and in contact with the photosensitive resin layer and the cover film, and that the release layer contains an addition silicone polymer and a curing catalyst.

As to the base film of the laminate according to the present invention, a material that is flexible and has excellent dimensional stability is preferred. For example, a polyethylene terephthalate film, a polyethylene naphthalate film, a polybutylene terephthalate film, or a polycarbonate film can be used. Among these materials, a polyethylene terephthalate film that has excellent dimensional stability and high viscoelasticity is particularly preferred. The base film has a thickness of preferably 50 to 350 µm and more preferably 100 to 350 µm in terms of, for example, mechanical characteristics, form stability, or handleability of the printing plate. A known bonding layer may be provided between the base film and the photosensitive resin layer as necessary so as to improve the bonding therebetween.

The photosensitive resin layer of the laminate according to the present invention is not particularly limited as long as it is water-developable. For example, one containing a conjugated diene-based polymer (a), a photopolymerizable unsaturated compound (b), and a photopolymerization initiator (c) can be used. In the present invention, a development step is performed with a water-based developer. Therefore, the photosensitive resin layer preferably further contains a hydrophilic compound (d). As to a photosensitive resin composition containing the components (a) to (d), for example, one described in Japanese Patent Application Laid-Open (JP-A) No. 2005-148588 can suitably be used.

As to the conjugated diene-based polymer (a), a conjugated diene-based polymer obtained from water-dispersible latex is preferred, and a conventionally known synthetic polymer compound used for a flexographic printing plate precursor can be used. The photosensitive resin layer preferably contains, as the water-dispersible latex, at least one type of latex selected from the group consisting of butadiene latex, acrylonitrile-butadiene latex, styrene-butadiene latex, and isoprene latex, and further preferably contains both butadiene latex and acrylonitrile-butadiene latex in terms of water-developability. When a conjugated diene-based polymer obtained from water-dispersible latex is used, the conjugated diene-based polymer is preferably intramolecularly crosslinked. The conjugated diene-based polymer may, as desired, be modified with a (meth)acrylic group, a carboxyl group, silicone, fluorine, or the like. The water-dispersible latex can appropriately be selected from a variety of types of synthetic latex and natural latex that are commercially available.

As to the photopolymerizable unsaturated compound (b), one that is used for a flexographic printing plate precursor and is conventionally known can be used. The photosensitive resin layer preferably contains a photopolymerizable monomer such as a meth(acrylate) having a number-average molecular weight of 100 or more and 600 or less, and further preferably contains a photopolymerizable oligomer such as a meth(acrylate) having a number-average molecular weight of more than 600 and 20000 or less in addition to the photopolymerizable monomer. The photopolymerizable oligomer is not particularly limited as long as it has a number-average molecular weight in the range of more than 600 and 20000 or less. Examples thereof include one obtained by adding a (meth)acrylate group to a butadiene oligomer or an isoprene oligomer, and urethane (meth) acrylate.

As to the photopolymerization initiator (c), one having functions of causing self decomposition by absorption of light or generating a radical by hydrogen abstraction is preferably used. Examples of such a photopolymerization initiator include a benzoin alkyl ether, a benzophenone, an anthraquinone, a benzyl, an acetophenone, and a diacetyl. Examples include benzophenone, chlorobenzophenone, benzoin, acetophenone, benzil, benzoin methyl ether, benzoin ethyl ether, benzoin isopropyl ether, benzoin isobutyl ether, benzyl dimethyl ketal, benzyl diethyl ketal, benzyl diisopropyl ketal, anthraquinone, 2-ethylanthraquinone, 2-methylanthraquinone, 2-allylanthraquinone, 2-chloroanthraquinone, thioxanthone, 2-chlorothioxanthone, and 1-hydroxycyclohexane-1-ylphenylketone. The photopolymerization initiator is preferably a compound formed of two types of materials, i.e. benzyl alkyl ketal-based and benzophenone-based materials, so as to enable efficient use of light energy of post exposure and exposure with a germicidal lamp.

The hydrophilic compound (d) is used for improving the water developability, and is, for example, a compound containing, in a molecule thereof, a hydrophilic group such as a carboxylic acid, a carboxylate, a sulfonic acid, a sulfonate, a hydroxyl group, an amino group, a phosphoric acid group, ethylene oxide, and propylene oxide, and the compound is itself water-soluble or water-dispersible. The hydrophilic compound may be a low-molecular-weight compound, an oligomer, a high-molecular-weight compound, or a hydrophilic polymer. Specific examples of the hydrophilic compound include a polyhydric alcohol, a polyvalent carboxylic acid, an ester compound of a polyvalent carboxylic acid, an acrylic polymer, a polyalkylene glycol-modified polymer, a urethane polymer, a polyamide polymer, and a polyester polymer. When a hydrophilic copolymer is used, internally crosslinked polymer particles containing a unit derived from a hydrophilic unsaturated monomer are preferred. Examples of these polymer particles include water-dispersible latex obtained by dispersing polymer particles as dispersoids in water, wherein the polymer particles have been obtained through emulsion polymerization of a hydrophilic unsaturated monomer, and another monomer copolymerizable therewith as necessary.

In addition to the components (a) to (d), the photosensitive resin layer of the laminate according to the present invention can appropriately contain, for the purpose of improving various characteristics, other component such as a plasticizer, an ultraviolet absorber, a thermal polymerization inhibitor (stabilizer), a surface-tension modifier, thermoplastic resin elastomer, solid rubber, a dye, a pigment, a defoamer, and a flocculation inhibitor, as far as the effects of the present invention is not inhibited.

As to the cover film of the laminate according to the present invention, a material that is flexible and has excellent dimensional stability is preferred, and its examples include thermoplastic resin support such as a polyethylene terephthalate film, a polyethylene naphthalate film, and a polybutylene terephthalate film. Among these materials, a polyethylene terephthalate film that has excellent dimensional stability and high viscoelasticity is particularly preferred. The cover film has a thickness of preferably 50 to 350 µm and more preferably 70 to 250 µm in terms of, for example, mechanical characteristics, form stability, or handleability of the printing plate during its production.

The release layer of the laminate according to the present invention contains an addition silicone polymer and a curing catalyst as a curing agent. As to the addition silicone polymer, a silicone polymer containing an alkenyl group at an end and/or a side chain thereof is preferred. Examples of the alkenyl group include a vinyl group, an allyl group, a propenyl group, a hexenyl group, an octenyl group, and a decenyl group. Among them, a vinyl group, an allyl group, and a hexenyl group are preferred in terms of curing properties. Commercial examples of the addition silicone polymer include KS-3650, KS-774, KS-775, KS-778, KS-779H, KS-843, KS-847, KS-847H, KS-847T, KS-838, KS-856, X-62-2422, X-62-2461, X62-2829, X-62-1387, X-62-5039, X-62-5040, KNS-3051, X-62-1496, KNS320A, KNS316, X-62-1574A/B, X-62-7052, X-62-7028A/B, X-62-7619, and X-62-7213 manufactured by Shin-Etsu Chemical Co., Ltd.; and SD7220, SD7226, SD7223, SD7292, SD7333, SRX211, SRX357, SRX345, LTC750A, LTC760A, LTC851, LTC759, LTC755, LTC761, LTC856, LTC310, LTC303E, LTC300B, and LTC350G manufactured by Dow Corning Toray Co., Ltd.

The addition silicone polymer containing an alkenyl group may also contain a hydrosilyl group (SiH) in a molecule thereof. Commercial examples include KS-3650, KS-843, KS-847, KS-847H, KS-847T, X62-2829, and KS838 manufactured by Shin-Etsu Chemical Co., Ltd.; and SD7333, SRX357, SRX345, LTC310, LTC303E, LTC300B, LTC350G, LTC750A, LTC851, LTC759, LTC755, LTC761, and LTC856 manufactured by Dow Corning Toray Co., Ltd.

These addition silicone polymers may be used singly or in combination of two or more thereof. The release layer may also contain an addition silicone polymer containing no alkenyl group, as far as the performance is not lowered. In this case, a high-molecular-weight polymer that is less likely to bleed out is preferred.

The release layer contains an addition silicone polymer. Therefore, the release layer preferably contains a polyorganosiloxane compound (crosslinking agent) containing a hydrosilyl group (SiH). Use of such polyorganosiloxane compound (crosslinking agent) can facilitate the progress of an addition reaction, and, as a result, enables impartation of excellent peeling properties. Specific examples of the polyorganosiloxane compound include 1,3,5,7-tetramethylcyclotetrasiloxane.

The curing catalyst has an effect of forming a crosslinking structure of the silicone polymer, and suppressing aggregation of the silicone polymer on the surface of the release layer or in the release layer. The curing catalyst is preferred to be a hydrosilylation catalyst. The hydrosilylation catalyst is not particularly limited as long as it has catalytic activity for a hydrosilylation reaction. Examples include elemental platinum, one including a carrier, such as an alumina, silica, and carbon black, and solid platinum supported thereon, chloroplatinic acid, a complex of chloroplatinic acid and an alcohol, an aldehyde, a ketone, or the like, a platinum-olefin complex, a platinum-vinyl siloxane complex, a platinum-phosphine complex, and a platinum-phosphite complex. Examples of a catalyst other than platinum compounds include RhCl (PPh)₃, RhCl₃, RhAl₂O₃, RuCl₃, IrCl₃, FeCl₃, AlCl₃, PdCl₂•2H₂O, NiCl₂, and TiCl₄. Among these examples, preferred in terms of a peeling effect are platinum catalysts, such as elemental platinum, one including a carrier, such as alumina, silica, and carbon black, and solid platinum supported thereon, a platinum-olefin complex, a platinum-vinyl siloxane complex, a platinum-phosphine complex, and a platinum-phosphite complex. The hydrosilylation catalyst is more preferred to be platinum complex such as a platinum-vinyl siloxane complex and a platinum-olefin complex. These catalysts may be used singly or in combination of two or more thereof.

As to a specific platinum catalyst, one may be produced by a known production method, or a commercially available product may be purchased. The platinum-vinyl siloxane complex can be produced by an ordinary method such as a production method disclosed in Japanese Patent Pregrant Publication (JP-B) No. 23679/72 and Japanese Patent Application Laid-Open (JP-A) No. 128748/99. Examples of the commercially available product include PL-3 and CAT-PL-50T manufactured by Shin-Etsu Chemical Co., Ltd.; and SRX212 manufactured by Dow Toray Co., Ltd.

The amount of the curing catalyst in the release layer is preferably 0.01 to 5.0 parts by mass, more preferably 0.015 to 4.0 parts by mass, and further preferably 0.02 to 3.0 parts by mass relative to 100 parts by mass of the addition silicone polymer. When the amount of the curing catalyst is small, a curing reaction does not sufficiently proceed, increasing the residual amount of Si-H groups and thus increasing the peel force. In addition, unreacted organopolysiloxane is present and becomes a transitional component. Accordingly, the unreacted organopolysiloxane may possibly transit to the photosensitive resin layer to be attached to a functional resin layer, and cause a decrease of bond strength. Further, problems are easily generated in which, when a functional resin layer is provided on the photosensitive resin layer, ultraviolet light applied is scattered, decreasing the image reproducibility, or the adhesiveness between the photosensitive resin layer and a functional resin layer is poor and therefore the functional resin layer is peeled.

The release layer may also contain a resin other than the addition silicone polymer unless the peeling properties are impaired. The release layer may contain, for example, an acrylic resin, a photocurable resin containing a photopolymerizable unsaturated group, or a thermosetting resin such as a phenolic resin, an epoxy resin, and a melamine resin. Blending a resin other than the addition silicone polymer can facilitate the control of the adhesiveness with the cover film and the peel strength of the release layer.

The release layer may also contain, in addition to the addition silicone polymer and the curing catalyst, a peel force modifier, such as a silane coupling agent, a crosslinking agent, a tackifier, a plasticizer, and a softener, for the purpose of adjusting the peel strength. Further, the release layer may also have other additive blended therein, as far as the peeling properties is not adversely affected. For example, a degradation inhibitor, a filler, a colorant, an antioxidant, a surfactant, an antistatic agent, or the like may be blended.

The release layer can be produced by applying a release layer-forming application solution onto the cover film. As to the application method, a conventionally known method such as reverse gravure coating, direct gravure coating, roll coating, die coating, bar coating, and curtain coating can be employed. The release layer-forming application solution can be prepared, for example, by mixing the addition silicone polymer and the curing catalyst with a solvent. As to the solvent, a ketone (for example, methyl ethyl ketone), an aromatic compound (for example, toluene), or the like can be used. These may be used singly or in combination of two or more thereof.

The release layer has a thickness of preferably 0.01 µm to 2 µm, more preferably 0.03 µm to 1.5 µm, and further preferably 0.05 µm to 1 µm. When the thickness is excessively small, the peel force may not possibly be sufficiently adjusted. On the other hand, when the thickness is excessively large, streaks are easily generated during the production.

The surface of the release layer which surface contacts with the photosensitive resin layer is preferred to have a surface roughness (Ra) of 0.01 to 0.2 µm. By setting the surface roughness to this range, it is possible to decrease the surface roughness of the surface of the photosensitive resin layer. As a result, while the photosensitive resin layer is in adhesion with a functional resin layer, intrusion of air bubbles or generation of wrinkles are unlikely to occur, and generation of defects can be reduced on the surface of the photosensitive resin layer on which the functional resin layer is stacked. The surface roughness of a surface of the release layer which surface contacts with the photosensitive resin layer means the surface roughness of the release layer in contact with the photosensitive resin layer.

The peel strength of the laminate according to the present invention is preferably 2.0 g/20 mm to 50.0 g/20 mm, and further preferably 3.0 g/20 mm to 20.0 g/20 mm. The peel strength is measured when the cover film is pulled together with the release layer from the laminate at a speed of 1000 mm/min and at an angle of 90°. By setting the peel strength to this range, it is possible to appropriately and uniformly peel the release layer from the photosensitive resin layer.

It is preferable that temperature dependency of the measured-value (value measured at 10°C - value measured at 30°C) of the peel strength is small. By decreasing the temperature dependency of the measured-value, the variations in peel strength attributed to the temperature can be decreased. Specifically, the difference between values of the peel strength measured at the temperatures 10°C and 30°C (value measured at 10°C - value measured at 30°C) is preferably 30.0 g/20 mm or less and more preferably 10.0 g/20 mm or less.

Next, a method for producing a flexographic printing plate precursor from the laminate according to the present invention will be described. In the laminate according to the present invention illustrated on the upper side in FIG. 5, the cover film is peeled and thus removed together with the release layer. Then, a resin layer surface of the functional resin layer illustrated on the lower side in FIG. 5 is directly stacked on the photosensitive resin layer, whereby a flexographic printing plate precursor to be used for producing a printing plate can efficiently be produced. As to the functional resin layer, one conventionally known in this field can be used. Examples include a mask layer having an image formed thereon, such as a high-resolution negative film; a heat-sensitive mask layer on which an image is formed by laser abrasion; another photosensitive resin layer having a hardness different from that of the resin of the photosensitive resin layer; another photosensitive resin layer having a concentration of photopolymerizable unsaturated groups or concentration of a photoinitiator different from that of the resin of the photosensitive resin layer; and another photosensitive resin layer having a surface energy different from that of the resin of the photosensitive resin layer. The functional resin layer may be stacked on a support film. The support film also plays a role as an oxygen barrier layer. Particularly when a high-resolution negative film is used as the functional resin layer, the effects of the present invention can easily be obtained. In the present invention, the negative film is a mask layer which is to be stacked on the photosensitive resin layer, and which has an image formed thereon. Ordinarily, the negative film means one comprising a support film and a mask layer provided thereon.

In the present invention, the high-resolution negative film means one capable of reproducing 1% to 95% halftone dots at 200 lines per inch. As to the high-resolution negative film, a negative film having a mask image formed thereon by a laser is preferred. Preferable negative film having a mask image formed thereon by a laser is one that comprises a heat-sensitive mask layer having the ultraviolet transmittance thereof partially increased due to a change in chromogenic properties or light transparency by a laser heating. This is because such a negative film can form finer high-light halftone dots. As described above, the support film in the negative film also plays a role as an oxygen barrier layer for reducing influences of oxygen. Further, in order to reduce scattering of ultraviolet light caused by the support film, a polarizing film may also be used as the support film, or the support film may contain therein an ultraviolet absorber or a dye having ultraviolet absorbency. As to the high-resolution negative film, a commercially available product can be used, or a high-resolution negative film can be produced by a known method. Examples of the commercially available high-resolution negative film include DITR4401 film manufactured by Eastman Kodak Company. Examples of the known high-resolution negative film include a mask layer comprising a support film having the refractive index controlled (Japanese Patent No. 5368432), a heat-sensitive mask layer comprising a support film and a barrier layer provided thereon, wherein the barrier layer contains an infrared absorbing compound (Japanese Patent No. 6449854), and a mask layer comprising a support that can be peeled and thus removed from the mask layer (Japanese Patent No. 4971311).

Examples of a specific printing plate precursor obtained from the laminate of the present invention include a flexographic printing plate precursor wherein, as the functional resin layer, a mask layer having an image formed thereon, such as a high-resolution negative film or a heat-sensitive mask layer on which an image is formed by laser abrasion is provided on the photosensitive resin layer; and a flexographic printing plate precursor wherein, as the functional resin layer, another photosensitive resin layer having a hardness different from that of the resin of the photosensitive resin layer, another photosensitive resin layer having a concentration of photopolymerizable unsaturated groups or concentration of a photoinitiator different from that of the resin of the photosensitive resin layer or another photosensitive resin layer having a surface energy different from that of the resin of the photosensitive resin layer is provided on the photosensitive resin layer. Specifically, the laminate according to the present invention can be used for producing a printing plate by: producing a flexographic printing plate precursor by directly stacking a resin layer surface of a functional resin layer on the photosensitive resin layer; providing a mask layer thereafter if the functional resin layer is another photosensitive resin layer; and performing an ordinary plate-making step comprising ultraviolet exposure, development, drying, post exposure, and the like. The functional resin layer may be removed in the plate-making step, or may, without being removed, remain as a resin layer on the photosensitive resin layer.

### Examples

The present invention will be more specifically illustrated by way of Examples although the present invention is never limited to those Examples.

### [Example 1]

### Preparation of release film

A release layer application solution having a concentration of 2 mass% was prepared by diluting 99 parts by mass of a vinyl group-containing addition silicone polymer (KS-847T manufactured by Shin-Etsu Chemical Co., Ltd.) and 1 part by mass of a curing catalyst (CAT-PL-50T manufactured by Shin-Etsu Chemical Co., Ltd.) with a methyl ethyl ketone/toluene mixed solvent (mixture mass ratio: 1 : 1). Next, the application solution was, using a wire bar, applied to a 100-µm-thick polyethylene terephthalate film (manufactured by TOYOBO Co., Ltd.) which will be used as a cover film so that the thickness of a dried application layer was 0.1 µm. Then, the application layer was dried and cured at 120°C for 40 seconds, whereby a release film comprising a release layer and a cover film was obtained.

### Preparation of photosensitive resin composition

A dope was prepared by mixing, in a container: 39 parts by mass of butadiene latex (Nipol LX111NF, non-volatile content 55 mass%, manufactured by Zeon Corporation) and 6 parts by mass of carboxyl-modified acrylonitrile-butadiene latex (Nipol SX1503, non-volatile content 42 mass%, manufactured by Zeon Corporation) as the conjugated diene-based polymer (a) obtained from water-dispersible latex; 17 parts by mass of oligobutadiene acrylate (ABU-4 manufactured by Kyoeisha Chemical Co., Ltd.), 6.4 parts by mass of trimethylolpropane trimethacrylate (Light Ester TMP manufactured by Kyoeisha Chemical Co., Ltd.), and 25 parts by mass of a metal chloride of the above-described diene-based polymer containing a carboxyl group at an end thereof as the photopolymerizable unsaturated compounds (b); 1 part by mass of the photopolymerization initiator (c) (Irgacure 651); 5.5 parts by mass of a butadiene oligomer (d) (LBR-352 manufactured by Kuraray Co., Ltd.); and 0.1 parts by mass of a thermal stabilizer (4-methoxyphenol). The dope was charged into a pressure kneader and had tetrahydrofuran and water removed therefrom at 80°C under reduced pressure, whereby a photosensitive resin composition was obtained.

### Preparation of laminate for producing a flexographic printing plate precursor

The photosensitive resin composition was disposed on a polyethylene terephthalate base film (support) (TOYOBO Co., Ltd., E5000, thickness 125 µm) coated with a copolymerized polyester-based adhesive, so as to form a photosensitive resin layer. Next, the release film was laid on the photosensitive resin layer in such a way that the release layer faces the photosensitive resin layer. The layer and films were pressure-bonded at 100°C by using a heat press machine, whereby a laminate for producing a flexographic printing plate precursor was obtained. The total thickness of this laminate was 1.14 mm.

### Preparation of functional resin layer

As to a functional resin layer, a high-resolution negative film (a mask layer having the ultraviolet transmittance thereof partially increased due to a change in chromogenic properties or light transparency by a laser heating) was prepared. Specifically, a negative film that comprises a 100-µm-thick support film having provided thereon 1% to 95% halftone dots at 200 lines per inch, a minimum isolated dot having a diameter of 100 µm, a minimum 1 point convex letter, a minimum 1 point concave letter, and a solid image was prepared from high-resolution negative film DITR4401 (manufactured by Eastman Kodak Company) capable of attaining a printing resolution of up to 200 lines per inch, by using a TRENDSETTER imager (manufactured by Eastman Kodak Company) enabling SQUARE spot thermal imaging with an 830-nm infrared laser diode.

### Production of flexographic printing plate precursor and flexographic printing plate

The cover film, together with the release layer, was peeled from the laminate for producing a flexographic printing plate precursor. Then, the laminate for producing a flexographic printing plate precursor was laminated with the functional resin layer, in such a way that a resin layer surface (surface opposite from the support film) thereof faces the photosensitive resin layer of the laminate, whereby a flexographic printing plate precursor was obtained. The obtained printing plate precursor was subjected to plate making according to the following method so as to produce a printing plate.

First, the printing plate precursor was subjected to back exposure performed for 10 seconds from the side of the support (polyethylene terephthalate base film) of the printing plate precursor. Subsequently, the printing plate precursor was subjected to main exposure performed for 7 minutes. Thereafter, the printing plate precursor was developed by a developing machine (Stuck System, 1% aqueous solution of washing soap, 40°C) manufactured by A & V Co., Ltd. for 8 minutes. Thereafter, water drops on the surface of the printing plate precursor were removed by a water draining rod. Thereafter, the printing plate precursor was dried by a drier set to 60°C for 10 minutes. Subsequently, the printing plate precursor was subjected to post exposure for 7 minutes and finally to irradiation with a germicidal lamp for 5 minutes, whereby a flexographic printing plate was obtained.

### [Example 2]

A release film was prepared in the same manner as in Example 1 except that, in the preparation of the release layer application solution, the vinyl group-containing addition silicone polymer (KS-847T manufactured by Shin-Etsu Chemical Co., Ltd.) was replaced with a 30 mass% toluene solution of a vinyl group-containing addition silicone polymer (KS-774 manufactured by Shin-Etsu Chemical Co., Ltd.). Next, a laminate for producing a flexographic printing plate precursor was prepared in the same manner as in Example 1, by using the obtained release film.

### [Example 3]

A release film was prepared in the same manner as in Example 1 except that, in the preparation of the release layer application solution, the vinyl group-containing addition silicone polymer (KS-847T manufactured by Shin-Etsu Chemical Co., Ltd.) was replaced with a hexenyl group-containing addition silicone polymer (LTC750A manufactured by Dow Corning Toray Co., Ltd.). Next, a laminate for producing a flexographic printing plate precursor was prepared in the same manner as in Example 1, by using the obtained release film.

### [Example 4]

A release film was prepared in the same manner as in Example 1 except that, in the preparation of the release layer application solution, the curing catalyst (CAT-PL-50T manufactured by Shin-Etsu Chemical Co., Ltd.) was replaced with a curing catalyst (PL-3 manufactured by Shin-Etsu Chemical Co., Ltd.). Next, a laminate for producing a flexographic printing plate precursor was prepared in the same manner as in Example 1, by using the obtained release film.

### [Example 5]

A release film was prepared in the same manner as in Example 1 except that, in the preparation of the release layer application solution, the curing catalyst (CAT-PL-50T manufactured by Shin-Etsu Chemical Co., Ltd.) was replaced with a curing catalyst (SRX212 manufactured by Dow Toray Co., Ltd.). Next, a laminate for producing a flexographic printing plate precursor was prepared in the same manner as in Example 1, by using the obtained release film.

### [Example 6]

A release film was prepared in the same manner as in Example 1 except that, in the preparation of the release layer application solution, in addition to the addition silicone polymer and the curing catalyst, a crosslinking agent (1,3,5,7-tetramethylcyclotetrasiloxane) was blended at the blending ratio shown in Table 1. Next, a laminate for producing a flexographic printing plate precursor was prepared in the same manner as in Example 1, by using the obtained release film.

### [Example 7]

A release film was prepared in the same manner as in Example 1 except that, in the preparation of the release layer application solution, the vinyl group-containing addition silicone polymer (KS-847T manufactured by Shin-Etsu Chemical Co., Ltd.) was replaced with a mixture obtained by blending the vinyl group-containing addition silicone polymer (KS-847T manufactured by Shin-Etsu Chemical Co., Ltd.) and a hexenyl group-containing addition silicone polymer (LTC750A manufactured by Dow Corning Toray Co., Ltd.) at a solid-content mass ratio of 70/30. Next, a laminate for producing a flexographic printing plate precursor was prepared in the same manner as in Example 1, by using the obtained release film.

### [Example 8]

A release film was prepared in the same manner as in Example 1 except that the blending ratio of the curing catalyst was reduced as shown in Table 1. Next, a laminate for producing a flexographic printing plate precursor was prepared in the same manner as in Example 1, by using the obtained release film.

### [Comparative Example 1]

A laminate for producing a flexographic printing plate precursor was prepared in the same manner as in Example 1 except that a cover film having no release layer provided thereon was used.

### [Comparative Example 2]

A release film was prepared in the same manner as in Example 1 except that, in the preparation of the release layer application solution, the vinyl group-containing addition silicone polymer (KS-847T manufactured by Shin-Etsu Chemical Co., Ltd.) was replaced with a silicone polymer of non-addition type (X-52-8046 manufactured by Shin-Etsu Chemical Co., Ltd.). A laminate for producing a flexographic printing plate precursor was prepared in the same manner as in Example 1, by using the obtained release film.

### [Comparative Example 3]

A release film containing an amino resin was prepared according to a method for preparing a peel force adjustment layer disclosed in Japanese Patent No. 5903854. Next, a laminate for producing a flexographic printing plate precursor was prepared in the same manner as in Example 1, by using the obtained release film.

### [Comparative Example 4]

A release film made of acrylic resin was prepared according to a method for preparing a peel force adjustment layer disclosed in Japanese Patent No. 6135040. Next, a laminate for producing a flexographic printing plate precursor was prepared in the same manner as in Example 1, by using the obtained release film.

### [Comparative Example 5]

A release film was prepared in the same manner as in Example 1 except that the curing catalyst (CAT-PL-50T manufactured by Shin-Etsu Chemical Co., Ltd.) was not blended in the release layer application solution in Example 1. Next, a laminate for producing a flexographic printing plate precursor was prepared in the same manner as in Example 1, by using the obtained release film.

### [Reference Example 1]

As to the photosensitive resin layer, one that cannot be developed with water and is to be developed with a solvent was used.

A photosensitive resin composition that is to be developed with a solvent was prepared by kneading 100 parts by mass of a block copolymer (TUFPRENE 912 manufactured by Asahi Kasei Corp.), 10 parts by mass of liquid polybutadiene (NISSO-PB-B-1000 manufactured by Nippon Soda Co., Ltd.), and 2 parts by mass of 2,6-di-t-butyl-p-cresol at 170°C by using a kneader, subsequently decreasing the kneading temperature to 130°C, and adding 10 parts by mass of 1,6-hexanediol dimethacrylate, 0.01 part by mass of methylhydroquinone, and 1 part by mass of a photopolymerization initiator (Irgacure 651), followed by kneading.

The photosensitive resin composition was disposed on a polyethylene terephthalate base film (TOYOBO Co., Ltd., E5000, thickness 125 µm) coated with a copolymerized polyester-based adhesive, so as to form a photosensitive resin layer. Next, a film (TOYOBO Co., Ltd., E5000, thickness 100 µm) having no release layer coated thereon was laid on the photosensitive resin layer. The layer and films were pressure-bonded at 100°C by using a heat press machine, whereby a laminate for producing a flexographic printing plate precursor was obtained. The total thickness of this laminate was 1.14 mm.

The cover film was peeled from the obtained laminate for producing a flexographic printing plate precursor, and the laminate for producing a flexographic printing plate precursor was laminated with the same functional resin layer as in Example 1, in such a way that a resin layer surface thereof faces the photosensitive resin layer of the laminate, whereby a flexographic printing plate precursor was obtained. The obtained printing plate precursor was subjected to plate making according to the following method so as to produce a printing plate.

First, the printing plate precursor was subjected to back exposure performed for 10 seconds from the side of the polyester support of the printing plate precursor. Subsequently, the printing plate precursor was subjected to main exposure performed for 7 minutes. Thereafter, the printing plate precursor was developed by a developing machine (Stuck System) (mineral spirit was used as the developer) manufactured by A & V Co., Ltd. for 8 minutes. Thereafter, the printing plate precursor was dried by a drier set to 60°C for 120 minutes. Subsequently, the printing plate precursor was subjected to post exposure for 7 minutes and finally to irradiation with a germicidal lamp for 5 minutes, whereby a flexographic printing plate was obtained.

The laminates and the printing plates of the examples, the comparative examples, and the reference example described above were evaluated for the following characteristics (1) to (6). The evaluation methods are as follows.

### (1) Force necessary for peeling cover film (10°C, 30°C)

The prepared laminate for producing a flexographic printing plate precursor was cut into 120 mm × 20 mm so as to prepare a test piece. Then, an end of the cover film of the test piece was peeled with a fingertip. Then, the test piece was set in a peeling test machine and pulled at a speed of 10000 mm/min and at an angle of 90°, and the peel strength (g/20 mm) of the test piece was measured.

The measurement was performed in environments of 10°C and 30°C. The peel force was evaluated by the following criteria.

oo: The peel strength is in the range of 3.0 g/20 mm or more and 20.0 g/20 mm or less.

o: The peel strength is out of the range of oo, but in the range of 2.0 g/20 mm or more and 50.0 g/20 mm or less.

×: The peel strength is out of both ranges of oo and o.

### (2) Temperature dependency of the peel strength (value measured at 10°C - value measured at 30°C)

In order to evaluate the temperature dependency of the peel strength of the release layer, the peel strength was measured at the temperatures 10°C and 30°C, and the difference between the measured values thereof was evaluated. The smaller the difference (value measured at 10°C - value measured at 30°C) between the measured values of the peel strength is, the smaller the temperature dependency of the peel strength is. The temperature dependency of the peel strength was evaluated by the following criteria.

oo: The difference between the measured values of the peel strength is 10 g/20 mm or less.

o: The difference between the measured values of the peel strength is more than 10 g/20 mm and 20 g/20 mm or less.

×: The difference between the measured values of the peel strength is more than 20 g/20 mm.

### (3) Storage stability (3 months) of peel strength;

After the obtained laminate was stored at 30°C, 80%RH for 3 months, the strength necessary for peeling the cover film of the laminate was measured at 10°C by the same method as in "(1) Force necessary for peeling cover film (10°C, 30°C)", and the peel force was evaluated.

### (4) Presence or absence of bleed-out phenomenon

After the obtained laminates were separately stored for 1 month respectively in environments of 20°C, 65%RH and 30°C, 80%RH, it was determined by visual inspection whether or not the resin bled out from the release layer when the cover film was peeled. The evaluation was performed by the following criteria depending on the presence or absence of a bleed-out phenomenon.

o: No bleed-out phenomenon observed.

×: Bleed-out phenomenon observed.

### (5) Surface roughness (Ra) of release layer

The surface roughness (Ra) of the release layer is the surface roughness (Ra) of the surface of the release layer in the release film. The measurement was performed by a confocal method using a confocal laser microscope. Specifically, confocal laser microscope VK9510 manufactured by KEYENCE CORPORATION was used as the confocal laser microscope. The object lens magnification was set to 50 times. A sample with a size of 10 cm (length) × 10 cm (width) was cut out from the release layer. Then, the sample was placed on a measurement stage of the confocal laser microscope, and measured for the surface roughness (Ra) at total 20 locations while the sample was moved by about 5 mm in the vertical direction and/or the horizontal direction. The average value of those measured values of the surface roughness (Ra) was defined as the surface roughness (Ra) of the release layer.

### (6) Image reproducibility of printing plate precursor

After the obtained laminates were separately stored for 1 month respectively in environments of 20°C, 65%RH and 30°C, 80%RH, flexographic printing plate precursors were produced as described above. Then, the image reproducibility was evaluated using the obtained flexographic printing plate precursors.

The printing plate precursor exhibiting no unevenness of adhesion (scattering of ultraviolet light) was evaluated as o, the printing plate precursor partially exhibiting unevenness of adhesion was evaluated as Δ, and the printing plate precursor entirely exhibiting unevenness of adhesion was evaluated as ×.

Table 1 shows the details and the evaluation results of the laminates of the examples, the comparative examples, and the reference example.

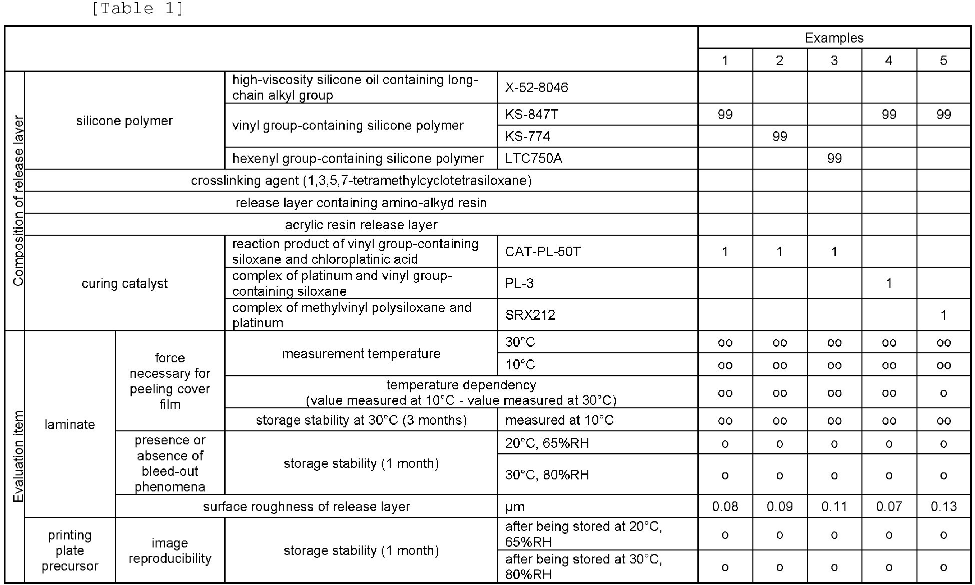

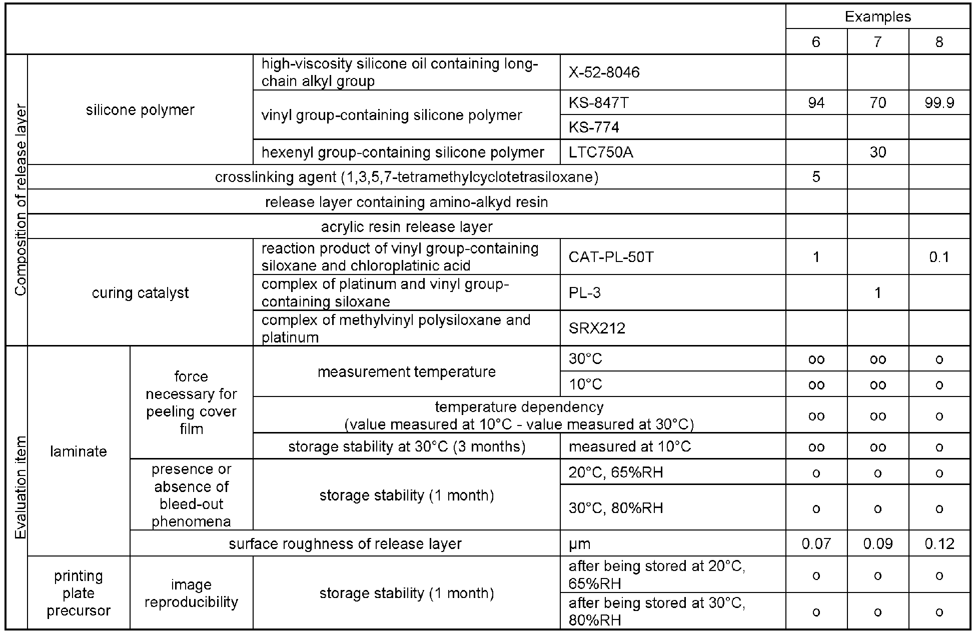

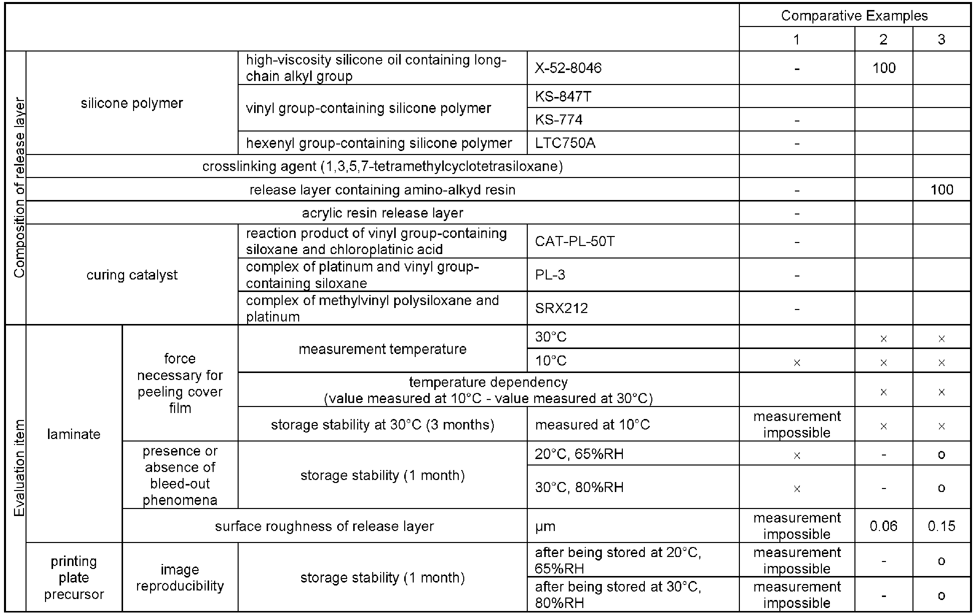

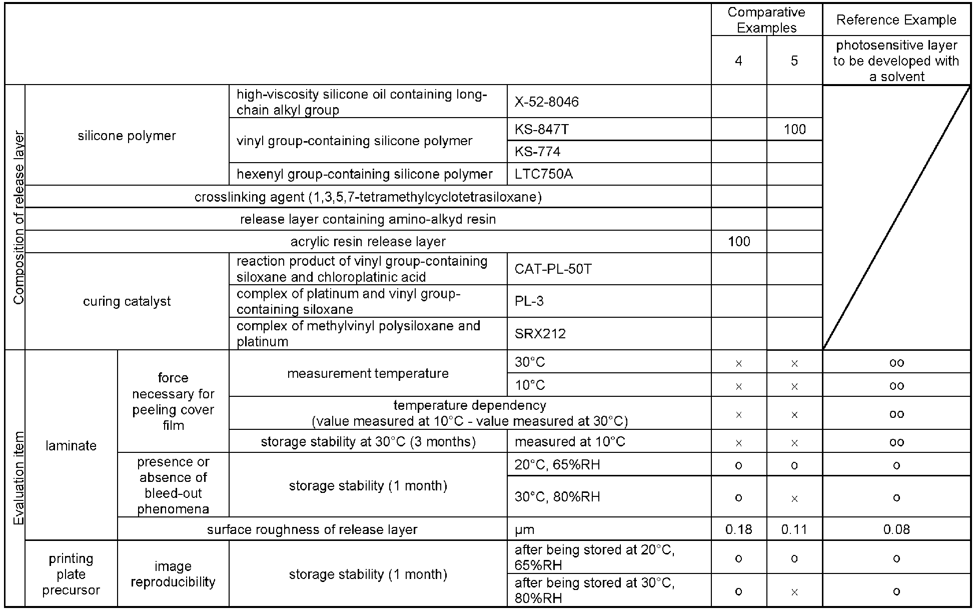

As is understood from Table 1, in all the laminates of Examples 1 to 8 satisfying the requirements of the present invention, the force necessary for peeling the cover film was in the appropriate range, and the difference (value measured at 10°C - value measured at 30°C) in peel strength between the temperatures was small (that is, the temperature dependency was small). Further, even after the storage at 30°C for 3 months, the change in the force necessary for peeling the cover film was small. This would mean that the laminates of Examples 1 to 8 exhibited excellent storage stability. Accordingly, in the laminates of Examples 1 to 8, a functional resin layer could be easily stacked thereon without being affected by an influence of seasonal variation, and could give high-quality printing plate precursors, and the obtained printing plate precursors exhibited excellent image reproducibility.

In contrast, in Comparative Example 1, it was impossible to peel the cover film due to the lack of the release layer. In Comparative Example 2, it was impossible to appropriately adjust the peel strength and suppress a bleed-out phenomenon due to the fact that the release layer did not contain addition silicone polymer. As a result, the printing plate precursor exhibited poor image reproducibility and could not fulfill the role of a printing plate precursor. In Comparative Example 3 in which the release layer containing an amino resin was used and Comparative Example 4 in which the release layer containing an acrylic resin was used, the force necessary for peeling the cover film was out of the appropriate range, and it was difficult to peel the cover film particularly at a low temperature of 10°C. In Comparative Example 5, it was impossible to appropriately adjust the peel strength and suppress a bleed-out phenomenon due to the fact that the release layer did not contain curing catalyst.

### Industrial Applicability

The laminate for producing a flexographic printing plate precursor according to the present invention can achieve excellent cover film peeling properties even when stored in an environment having variations in temperature and humidity, and therefore can provide a water-developable flexographic printing plate precursor that does not generate quality degradation due to trouble such as migration of a silicone polymer to a surface of a photosensitive resin layer. Accordingly, the present invention is very useful in the industry requiring a high-resolution water-developable flexographic printing plate precursor.

## Claims

1. A laminate for producing a water-developable flexographic printing plate precursor, comprising a base film, a photosensitive resin layer, and a cover film stacked in this order, wherein a release layer is provided between said photosensitive resin layer and said cover film and in contact with said photosensitive resin layer and said cover film, and wherein said release layer contains an addition silicone polymer and a curing catalyst.

2. The laminate for producing a flexographic printing plate precursor according to claim 1, wherein said addition silicone polymer contains an alkenyl group at an end and/or a side chain thereof.

3. The laminate for producing a flexographic printing plate precursor according to claim 1, wherein said curing catalyst is a hydrosilylation catalyst.

4. The laminate for producing a flexographic printing plate precursor according to any of claims 1 to 3, wherein a surface of said release layer which surface contacts with said photosensitive resin layer has a surface roughness (Ra) of 0.01 to 0.2 µm.

5. The laminate for producing a flexographic printing plate precursor according to any of claims 1 to 3, wherein a peel strength measured when said cover film is pulled together with said release layer from the laminate at a speed of 1000 mm/min and at an angle of 90° is 2.0 g/20 mm to 50.0 g/20 mm.

6. The laminate for producing a flexographic printing plate precursor according to any of claims 1 to 3, wherein said photosensitive resin layer contains a conjugated diene-based polymer (a), a photopolymerizable unsaturated compound (b), and a photopolymerization initiator (c).

7. A method for producing a flexographic printing plate precursor, wherein the method comprises peeling said cover film together with said release layer from the laminate for producing a flexographic printing plate precursor according to any of claims 1 to 3, and then directly stacking a resin layer surface of a functional resin layer on said photosensitive resin layer, so as to produce a flexographic printing plate precursor.
